# EUROPEAN PATENT SPECIFICATION

(11) **EP 2 991 110 B1**
(45) Date of publication and mention of the grant of the patent: **30.01.2019**
(21) Application number: 15181918.2
(22) Date of filing: 21.08.2015
(51) Int. Cl.: H01L 23/525, H01L 23/62, H01L 27/02, H01L 29/861

(54) **CIRCUIT PROTECTION DEVICE**
VORRICHTUNG ZUM SCHUTZ VON SCHALTKREISEN
DISPOSITIF DE PROTECTION DE CIRCUIT

(30) Priority: 25.08.2014 CN 201420481154 U
(43) Date of publication of application: 02.03.2016
(73) Proprietor: Littelfuse Electronics (Shanghai) Co., Ltd., Shanghai (CN)
(72) Inventor: FANG, Yan, Shanghai 200233 (CN); WANG, Bin, Shanghai 200233 (CN); YE, Jianzhe, Shanghai 200233 (CN); GUO, Tao, Shanghai 200233 (CN); LIU, Jianyong, Shanghai (CN)
(74) Representative: Johnstone, Douglas Ian

(56) References cited:
- EP-A2- 1 189 325
- CN-U- 202 307 878
- JP-A- 2005 340 404
- US-A1- 2006 118 904

## Description

### BACKGROUND OF THE INVENTION

### Field of the Invention

Embodiments of the present invention generally relate to a circuit protection device, and particularly, to a circuit protection device comprising a thermal fuse.

### Description of the Related Art

In prior arts, a thermal fuse and a diode may be utilized to achieve overcurrent and overvoltage protection for a circuit. Generally, the thermal fuse is connected in series with the protected circuit, and the diode has a cathode end connected to the protected circuit and a grounded anode end. When an overcurrent flows through the circuit, the thermal fuse will be heated up and blown, so that the circuit is switched off timely, thereby electrical devices and apparatus connected with the circuit are protected. When the circuit is applied with an overvoltage, the diode will be reversely broken-down, and an electrical current will flow directly from the diode to an earth terminal, so that a voltage from an output terminal of the circuit is pulled down to a low voltage in an instant; meanwhile, the thermal fuse will be heated up and blown, and finally the circuit is switched off, thereby electrical devices and apparatus connected with the circuit are protected.

In prior arts, however, the thermal fuse and the diode are discrete parts separated from each other, and need to be independently welded onto the protected circuit through lead wires, which is time-consuming and laborious and inconvenient to use. In addition, it will lead to an incompact overall structure and a larger volume of the circuit. EP 1,189,325 discloses an electronic device protection circuit including a zener diode and a thermal fuse in a stacked arrangement.

### SUMMARY OF THE INVENTION

The present invention has been made to overcome or alleviate at least one aspect of the above mentioned problems and disadvantages.

It would be advantageous to provide a circuit protection device, which is very convenient to use, thereby time and labor are saved.

It would also be advantageous to provide a circuit protection device with a compact structure and a smaller volume.

According to the invention, there is provided a circuit protection device according to any one of the appended claims.

According to one exemplary embodiment of the present disclosure, the first electrode surface of the diode is fitted on a top surface of the first insulation layer.

According to a further exemplary embodiment of the present disclosure, a conductive via is formed in the first insulation layer, and the first electrode surface of the diode is electrically connected to the first electrode end of the thermal fuse through the conductive via.

According to a further exemplary embodiment of the present disclosure, the first insulation layer is formed into a plate shape, and the diode is formed into a sheet shape and stacked on the first insulation layer.

According to a further exemplary embodiment of the present disclosure, the first exterior electrode pad is electrically connected to the first electrode end of the thermal fuse through a first conductive via formed in the first insulation layer.

According to a further exemplary embodiment of the present disclosure, the second exterior electrode pad is electrically connected to the second electrode end of the thermal fuse through a second conductive via formed in the first insulation layer.

According to a further exemplary embodiment of the present disclosure, the circuit protection device further comprises: an electrical connection member having one end electrically connected to the second electrode surface of the diode and the other end electrically connected to the third exterior electrode pad through a third conductive via formed in the first insulation layer.

According to a further exemplary embodiment of the present disclosure, the electrical connection member is a plate shaped electrical connection sheet comprising: a first portion parallel to and electrically connected to the second electrode surface of the diode; and a second portion perpendicular to the first portion and electrically connected to the third conductive via.

According to a further exemplary embodiment of the present disclosure, the diode and the electrical connection member are packaged in the second insulation layer.

According to a further exemplary embodiment of the present disclosure, the first electrode surface of the diode is a cathode surface, and the second electrode surface of the diode is an anode surface.

According to a further exemplary embodiment of the present disclosure, the second exterior electrode pad, which is electrically connected to the second electrode end of the thermal fuse is an input terminal of voltage or electrical current; the first exterior electrode pad, which is electrically connected to the first electrode end of the thermal fuse and the first electrode surface of the diode is an output terminal of voltage or electrical current; and the third exterior electrode pad, which is electrically connected to the second electrode surface of the diode is an earth terminal.

According to a further exemplary embodiment of the present disclosure, surfaces of the first exterior electrode pad, the second exterior electrode pad and the third exterior electrode pad are within the same plane.

According to a further exemplary embodiment of the present disclosure, an internal cavity is formed in the first insulation layer, and a middle part of the thermal fuse is received within the internal cavity.

In the circuit protection device according to various embodiments of the present disclosure, the thermal fuse and the diode are incorporated into one single circuit protection device, which can be simply soldered to the protected circuit (board) in one single process through SMT and is convenient to use. Further, in the present disclosure, the whole circuit protection device has a very compact structure and a smaller volume.

### BRIEF DESCRIPTION OF THE DRAWINGS

The above and other features and advantages of the present invention will become more apparent by describing in detail exemplary embodiments thereof with reference to the accompanying drawings, in which:
Fig. 1 is a schematic cross sectional view showing a circuit protection device according to one embodiment of the present disclosure; and
Fig. 2 is a circuit principle diagram of the circuit protection device shown in Fig. 1.

### DETAILED DESCRIPTION OF PREFERRED EMBODIMENTS OF THE INVENTION

Exemplary embodiments of the present invention will be described hereinafter in detail with reference to the attached drawings, wherein the like reference numbers refer to the like elements. The present invention may, however, be embodied in many different forms and should not be construed as being limited to the embodiment set forth herein; rather, these embodiments are provided so that the present invention will be thorough and complete, and will fully convey the concept of the disclosure to those skilled in the art.

In the following detailed description, for purposes of explanation, numerous specific details are set forth in order to provide a thorough understanding of the disclosed embodiments. However, tt will be apparent that one or more embodiments may be practiced without these specific details. In other instances, well-known structures and devices are schematically shown in order to simplify the drawing.

According to one general inventive concept of the present invention, there is provided a circuit protection device, comprising: a thermal fuse having a first electrode end and a second electrode end opposite to the first electrode end; and a diode having a first electrode surface and a second electrode surface opposite to the first electrode face, wherein the thermal fuse is packaged in a first insulation layer, and a first exterior electrode pad, a second exterior electrode pad and a third exterior electrode pad are provided on a bottom surface of the first insulation layer; the diode is packaged in a second insulation layer; and wherein the first electrode surface of the diode and the first electrode end of the thermal fuse are electrically connected to the first exterior electrode pad, the second electrode end of the thermal fuse is electrically connected to the second exterior electrode pad, and the second electrode surface of the diode is electrically connected to the third exterior electrode pad.

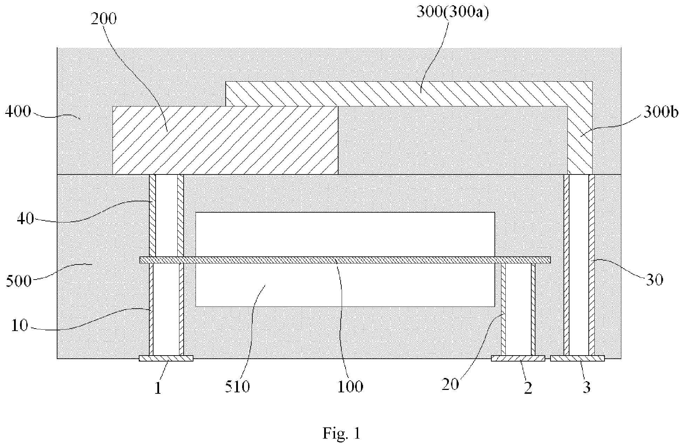

Fig. 1 is a schematic cross sectional view showing a circuit protection device according to one embodiment of the present disclosure.

In one embodiment of the present disclosure, as shown in Fig. 1, the circuit protection device mainly comprises a thermal fuse 100 and a diode 200.

In the illustrated embodiment, as shown in Fig. 1, the thermal fuse 100 has a first electrode end (the left end in Fig. 1) and a second electrode end (the right end in Fig. 1) opposite to the first electrode end.

In the illustrated embodiment, as shown in Fig. 1, the diode 200 has a first electrode surface (the lower surface in Fig. 1) and a second electrode surface (the upper surface in Fig. 1) opposite to the first electrode surface.

In one embodiment of the present disclosure, as shown in Fig. 1, the thermal fuse 100 is packaged in a first insulation layer 500, the first electrode surface of the diode 200 is fitted on a top surface of the first insulation layer 500, and the diode 200 is packaged in a second insulation layer 400.

With continued reference to Fig. 1, in the illustrated embodiment, the first electrode surface of the diode 200 is electrically connected to the first electrode end of the thermal fuse 100 through a conductive via 40 formed in the first insulation layer 500.

As shown in Fig. 1, a first exterior electrode pad 1, a second exterior electrode pad 2 and a third exterior electrode pad 3 are provided on a bottom surface of the first insulation layer 500. In the illustrated embodiment, lower surfaces of the first exterior electrode pad 1, the second exterior electrode pad 2 and the third exterior electrode pad 3 are located within the same plane, such that the first exterior electrode pad 1, the second exterior electrode pad 2 and the third exterior electrode pad 3 may be soldered to a circuit board in one single process through surface mounting technology (SMT), thereby providing very convenient operations.

In the embodiment shown in Fig. 1, the first electrode surface of the diode 200 and the first electrode end of the thermal fuse 100 are electrically connected to the first exterior electrode pad 1, the second electrode end of the thermal fuse 100 is electrically connected to the second exterior electrode pad 2, and the second electrode surface of the diode 200 is electrically connected to the third exterior electrode pad 3. In such a manner, the thermal fuse 100 and the diode 200 can be electrically connected to the protected circuit through the first exterior electrode pad 1, the second exterior electrode pad 2 and the third exterior electrode pad 3 without using lead wires, and thus providing very convenient operations.

In one embodiment of the present disclosure, as shown in Fig. 1, the first exterior electrode pad 1 is electrically connected to the first electrode end of the thermal fuse 100 through a first conductive via 10 formed in the first insulation layer 500.

In one embodiment of the present disclosure, as shown in Fig. 1, the second exterior electrode pad 2 is electrically connected to the second electrode end of the thermal fuse 100 through a second conductive via 20 formed in the first insulation layer 500.

In one embodiment of the present disclosure, as shown in Fig. 1, the circuit protection device further comprises an electrical connection member 300 packaged in the second insulation layer 400, the electrical connection member 300 has one end electrically connected to the second electrode surface of the diode 200 and the other end electrically connected to the third exterior electrode pad 3 through a third conductive via 30 formed in the first insulation layer 500.

In one embodiment of the present disclosure, the electrical connection member 300 is a plate shaped electrical connection sheet. The electrical connection member 300 comprises a first portion 301 and a second portion 302. The first portion 301 of the electrical connection member 300 is parallel to and electrically connected to the second electrode surface of the diode 200. The second portion 302 of the electrical connection member 300 is perpendicular to the first portion 301 and electrically connected to the third conductive via 30.

In one embodiment of the present disclosure, the first insulation layer 500 is formed into a plate shape, and the diode 200 is formed into a sheet shape and stacked on the first insulation layer 500, which can reduce the thickness of the circuit protection device.

In one embodiment of the present disclosure, as shown in Fig. 1, an internal cavity 510 is formed in the first insulation layer 500, and a middle part of the thermal fuse 100 is received within the internal cavity 510. The first and second electrode ends of the thermal fuse 100 are held in the first insulation layer 500.

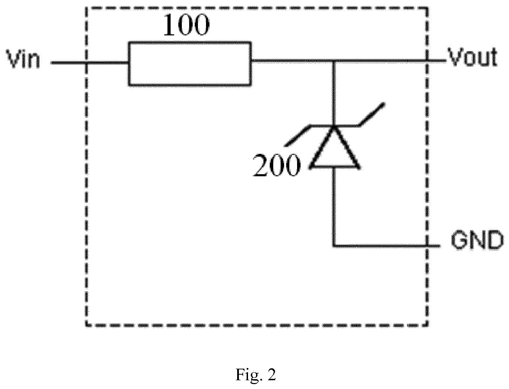

Fig. 2 is a circuit principle diagram of the circuit protection device shown in Fig. 1.

As can be seen clearly from the circuit principle diagram of the circuit protection device shown in Fig. 2, the first electrode surface of the diode 200 is a cathode surface, and the second electrode surface of the diode 200 is an anode surface.

In the illustrated embodiment, as shown in Fig. 1 and Fig. 2, the second exterior electrode pad 2, which is electrically connected to the second electrode end of the thermal fuse 100, is a voltage or current input terminal Vin shown in Fig. 2.

In the illustrated embodiment, as shown in Fig. 1 and Fig. 2, the first exterior electrode pad 1, which is electrically connected to the first electrode end of the thermal fuse 100 and the first electrode surface of the diode 200, is a voltage or current output terminal Vout shown in Fig. 2.

In the illustrated embodiment, as shown in Fig. 1 and Fig. 2, the third exterior electrode pad 3, which is electrically connected to the second electrode surface of the diode 200, is an earth terminal GND shown in Fig. 2.

It can be known clearly from the circuit principle diagram of the circuit protection device shown in Fig. 2 that, when an overcurrent flows through the circuit, an electrical current flowing through the thermal fuse 100 will be very large, resulting in a rapid temperature rise and a breakdown of the thermal fuse 100, thereby enabling overcurrent protection for the circuit in time. When the circuit is applied with an overvoltage, the diode 200 will be reversely broken-down by an over-high voltage, and an electrical current will flow directly from the diode to the earth terminal, so that an voltage from the output terminal of the circuit is pulled down to a low voltage in an instant; meanwhile, over-high fault current flows through the thermal fuse and the diode 200, the thermal fuse will be heated up and blown, and finally the circuit is switched off. In the present disclosure, parameters of the thermal fuse and the diode 200 may be suitably designed and selected so that the thermal fuse is capable of being blown before the diode 200 is damaged.

It will be appreciated by those skilled in the art the above described embodiments are exemplary, and may be improved by those skilled in the art. The structures described in various embodiments may be combined freely without conflict in arrangement or principle.

Although the present disclosure has been described in conjunction with the attached drawings, the embodiments shown in the drawings are intended to exemplarily illustrate preferred embodiments of the present invention, and should not be interpreted as being limitative to the present invention.

It should be noted the term "comprise" does not exclude other elements or steps, and the term "a" or "an" does not exclude a plurality of elements or steps. Further, any reference number in claims should not be interpreted as being limitative to the scope of the present invention.

## Claims

1. A circuit protection device, comprising:
a first insulation layer (500);
a second insulation layer (400) positioned above a top surface of the first insulation layer;
a thermal fuse (100) packaged in the first insulation layer (500) and having a first electrode end and a second electrode end opposite to the first electrode end; and
a diode (200) packaged in the second insulation layer (400) and having a first electrode surface and a second electrode surface opposite to the first electrode surface,
**characterised by**:
a first exterior electrode pad (1) positioned on a bottom surface of the first insulation layer opposite the top surface of the first insulation layer, is electrically connected to the first electrode surface of the diode and the first electrode end of the thermal fuse,
a second exterior electrode pad (2) positioned on the bottom surface of the first insulation layer, is electrically connected to the second electrode end of the thermal fuse; and
a third exterior electrode pad (3) positioned on the bottom surface of the first insulation layer, is electrically connected to the second electrode surface of the diode.

2. The circuit protection device according to claim 1, wherein:
the first electrode surface of the diode (200) is fitted on the top surface of the first insulation layer (500).

3. The circuit protection device according to claim 1 or 2, wherein:
a conductive via (40) is formed in the first insulation layer (500), and the first electrode surface of the diode (200) is electrically connected to the first electrode end of the thermal fuse (100) through the conductive via (40).

4. The circuit protection device according to one of claims 1 to 3, wherein:
the first insulation layer (500) is formed into a plate shape, and the diode (200) is formed into a sheet shape and stacked on the first insulation layer (500).

5. The circuit protection device according to any one of claims 1 to 4, wherein:
the first exterior electrode pad (1) is electrically connected to the first electrode end of the thermal fuse (100) through a first conductive via (10) formed in the first insulation layer (500).

6. The circuit protection device according to claim 5, wherein:
the second exterior electrode pad (2) is electrically connected to the second electrode end of the thermal fuse (100) through a second conductive via (20) formed in the first insulation layer (500).

7. The circuit protection device according to claim 6, further comprising:
an electrical connection member (300) having one end electrically connected to the second electrode surface of the diode (200) and the other end electrically connected to the third exterior electrode pad (3) through a third conductive via (30) formed in the first insulation layer (500).

8. The circuit protection device according to claim 7, wherein the electrical connection member (300) is a plate shaped electrical connection sheet comprising:
a first portion (301) parallel to and electrically connected to the second electrode surface of the diode (200); and
a second portion (302) perpendicular to the first portion (301) and electrically connected to the third conductive via (30).

9. The circuit protection device according to claim 8, wherein,
the diode (200) and the electrical connection member (300) are packaged in the second insulation layer (400).

10. The circuit protection device according to claim 9, wherein:
the first electrode surface of the diode (200) is a cathode surface, and the second electrode surface of the diode (200) is an anode surface.

11. The circuit protection device according to claim 10, wherein:
the second exterior electrode pad (2), which is electrically connected to the second electrode end of the thermal fuse (100), is a voltage or current input terminal (Vin);
the first exterior electrode pad (1), which is electrically connected to the first electrode end of the thermal fuse (100) and the first electrode surface of the diode (200), is a voltage or current output terminal (Vout); and
the third exterior electrode pad (3), which is electrically connected to the second electrode surface of the diode (200), is an earth terminal (GND).

12. The circuit protection device according to claim 11, wherein:
surfaces of the first exterior electrode pad (1), the second exterior electrode pad (2) and the third exterior electrode pad (3) are within the same plane.

13. The circuit protection device according to one of claims 1 to 12, wherein:
an internal cavity (510) is formed in the first insulation layer (500), and a middle part of the thermal fuse (100) is received within the internal cavity (510).

## Patentansprüche

1. Schaltkreisschutzvorrichtung, die Folgendes umfasst:
eine erste Isolierschicht (500);
eine zweite Isolierschicht (400), die über einer oberen Fläche der ersten Isolierschicht positioniert ist;
eine Thermosicherung (100), die in die erste Isolierschicht (500) eingepackt ist und ein erstes Elektrodenende und ein zweites Elektrodenende gegenüber dem ersten Elektrodenende hat; und
eine Diode (200), die in die zweite Isolierschicht (400) eingepackt ist und eine erste Elektrodenoberfläche und eine zweite Elektrodenoberfläche gegenüber der ersten Elektrodenoberfläche hat,
**gekennzeichnet durch**:
ein erstes äußeres Elektrodenpad (1), das auf einer unteren Fläche der ersten Isolierschicht gegenüber der oberen Fläche der ersten Isolierschicht positioniert, elektrisch mit der ersten Elektrodenfläche der Diode und dem zweiten Elektrodenende der Thermosicherung verbunden ist,
ein zweites äußeres Elektrodenpad (2), das auf der unteren Fläche der ersten Isolierschicht positioniert und elektrisch mit dem zweiten Elektrodenende der Thermosicherung verbunden ist; und
ein drittes äußeres Elektrodenpad (3), das auf der unteren Fläche der ersten Isolierschicht positioniert und elektrisch mit der zweiten Elektrodenfläche der Diode verbunden ist.

2. Schaltkreisschutzvorrichtung nach Anspruch 1, wobei:
die erste Elektrodenfläche der Diode (200) auf die obere Fläche der ersten Isolierschicht (500) gesetzt ist.

3. Schaltkreisschutzvorrichtung nach Anspruch 1 oder 2, wobei:
eine leitfähige Durchkontaktierung (40) in der ersten Isolierschicht (500) ausgebildet ist und die erste Elektrodenfläche der Diode (200) elektrisch mit dem ersten Elektrodenende der Thermosicherung (100) durch die leitfähige Durchkontaktierung (40) verbunden ist.

4. Schaltkreisschutzvorrichtung nach einem der Ansprüche 1 bis 3, wobei:
die erste Isolierschicht (500) zu einer Plattenform ausgebildet ist und die Diode (200) zu einer Plattenform ausgebildet und auf die erste Isolierschicht (500) gestapelt ist.

5. Schaltkreisschutzvorrichtung nach einem der Ansprüche 1 bis 4, wobei:
das erste äußere Elektrodenpad (1) elektrisch mit dem ersten Elektrodenende der Thermosicherung (100) durch eine in der ersten Isolierschicht (500) ausgebildete erste leitfähige Durchkontaktierung (10) verbunden ist.

6. Schaltkreisschutzvorrichtung nach Anspruch 5, wobei:
das zweite äußere Elektrodenpad (2) elektrisch mit dem zweiten Elektrodenende der Thermosicherung (100) durch eine in der ersten Isolierschicht (500) ausgebildete zweite leitfähige Durchkontaktierung (20) verbunden ist.

7. Schaltkreisschutzvorrichtung nach Anspruch 6, die ferner Folgendes umfasst:
ein elektrisches Verbindungselement (300), von dem ein Ende elektrisch mit der zweiten Elektrodenfläche der Diode (200) und das andere Ende elektrisch mit dem dritten äußeren Elektrodenpad (3) durch eine in der ersten Isolierschicht (500) ausgebildete dritte leitfähige Durchkontaktierung (30) verbunden ist.

8. Schaltkreisschutzvorrichtung nach Anspruch 7, wobei das elektrische Verbindungselement (300) ein plattenförmiges elektrisches Verbindungsblech ist, das Folgendes umfasst:
einen ersten Abschnitt (301) parallel zu und elektrisch verbunden mit der zweiten Elektrodenfläche der Diode (200); und
einen zweiten Abschnitt (302) lotrecht zum ersten Abschnitt (301) und elektrisch mit der dritten leitfähigen Durchkontaktierung (30) verbunden.

9. Schaltkreisschutzvorrichtung nach Anspruch 8, wobei die Diode (200) und das elektrische Verbindungselement (300) in die zweite Isolierschicht (400) eingepackt sind.

10. Schaltkreisschutzvorrichtung nach Anspruch 9, wobei:
die erste Elektrodenfläche der Diode (200) eine Kathodenfläche ist und die zweite Elektrodenfläche der Diode (200) eine Anodenfläche ist.

11. Schaltkreisschutzvorrichtung nach Anspruch 10, wobei:
das zweite äußere Elektrodenpad (2), das elektrisch mit dem zweiten Elektrodenende der Thermosicherung (100) verbunden ist, ein Spannungs- oder Stromeingangsanschluss (Vin) ist;
das erste äußere Elektrodenpad (1), das elektrisch mit dem ersten Elektrodenende der Thermosicherung (100) und der ersten Elektrodenfläche der Diode (200) verbunden ist, ein Spannungs- oder Stromausgangsanschluss (Vout) ist; und
das dritte äußere Elektrodenpad (3), das elektrisch mit der zweiten Elektrodenfläche der Diode (200) verbunden ist, ein Erdanschluss (GND) ist.

12. Schaltkreisschutzvorrichtung nach Anspruch 11, wobei:
Oberflächen des ersten äußeren Elektrodenpads (1), des zweiten äußeren Elektrodenpads (2) und des dritten äußeren Elektrodenpads (3) in derselben Ebene liegen.

13. Schaltkreisschutzvorrichtung nach einem der Ansprüche 1 bis 12, wobei:
ein interner Hohlraum (510) in der ersten Isolierschicht (500) ausgebildet ist und ein mittlerer Teil der Thermosicherung (100) in dem internen Hohlraum (510) aufgenommen wird.

## Revendications

1. Dispositif de protection de circuit, comprenant :
une première couche d'isolation (500) ;
une seconde couche d'isolation (400) positionnée pardessus une surface supérieure de la première couche d'isolation ;
un fusible thermique (100) inséré dans la première couche d'isolation (500) et comportant une première extrémité d'électrode et une seconde extrémité d'électrode opposée à la première extrémité d'électrode ; et
une diode (200) insérée dans la seconde couche d'isolation (400) et comportant une première surface d'électrode et une seconde surface d'électrode opposée à la première surface d'électrode,
**caractérisé par** :
une première pastille d'électrode extérieure (1) positionnée sur une surface inférieure de la première couche d'isolation opposée à la surface supérieure de la première couche d'isolation, et connectée électriquement à la première surface d'électrode de la diode et à la première extrémité d'électrode du fusible thermique,
une deuxième pastille d'électrode extérieure (2) positionnée sur la surface inférieure de la première couche d'isolation, et connectée électriquement à la seconde extrémité d'électrode du fusible thermique ; et
une troisième pastille d'électrode extérieure (3) positionnée sur la surface inférieure de la première couche d'isolation, et connectée électriquement à la seconde surface d'électrode de la diode.

2. Dispositif de protection de circuit selon la revendication 1, dans lequel :
la première surface d'électrode de la diode (200) est ajustée sur la surface supérieure de la première couche d'isolation (500).

3. Dispositif de protection de circuit selon la revendication 1 ou 2, dans lequel :
un trou d'interconnexion conducteur (40) est formé dans la première couche d'isolation (500), et la première surface d'électrode de la diode (200) est connectée électriquement à la première extrémité d'électrode du fusible thermique (100) par le biais du trou d'interconnexion conducteur (40).

4. Dispositif de protection de circuit selon l'une des revendications 1 à 3, dans lequel :
la première couche d'isolation (500) est formé en forme de plaque, et la diode (200) est formée en forme de plaque et empilée sur la première couche d'isolation (500).

5. Dispositif de protection de circuit selon l'une quelconque des revendications 1 à 4, dans lequel :
la première pastille d'électrode extérieure (1) est connectée électriquement à la première extrémité d'électrode du fusible thermique (100) par le biais d'un premier trou d'interconnexion conducteur (10) formé dans la première couche d'isolation (500).

6. Dispositif de protection de circuit selon la revendication 5, dans lequel :
la deuxième pastille d'électrode extérieure (2) est connectée électriquement à la seconde extrémité d'électrode du fusible thermique (100) par le biais d'un deuxième trou d'interconnexion conducteur (20) formé dans la première couche d'isolation (500).

7. Dispositif de protection de circuit selon la revendication 6, comprenant en outre :
un élément de connexion électrique (300) comportant une extrémité connectée électriquement à la seconde surface d'électrode de la diode (200) et l'autre extrémité connectée électriquement à la troisième pastille d'électrode extérieure (3) par le biais d'un troisième trou d'interconnexion conducteur (30) formé dans la première couche d'isolation (500).

8. Dispositif de protection de circuit selon la revendication 7, dans lequel l'élément de connexion électrique (300) est une feuille de connexion électrique en forme de plaque comprenant :
une première partie (301) parallèle et connectée électriquement à la seconde surface d'électrode de la diode (200) ; et
une seconde partie (302) perpendiculaire à la première partie (301) et connectée électriquement au troisième trou d'interconnexion conducteur (30).

9. Dispositif de protection de circuit selon la revendication 8, dans lequel :
la diode (200) et l'élément de connexion électrique (300) sont insérés dans la seconde couche d'isolation (400) .

10. Dispositif de protection de circuit selon la revendication 9, dans lequel :
la première surface d'électrode de la diode (200) est une surface de cathode, et la seconde surface d'électrode de la diode (200) est une surface d'anode.

11. Dispositif de protection de circuit selon la revendication 10, dans lequel :
la deuxième pastille d'électrode extérieure (2), qui est connectée électriquement à la seconde extrémité d'électrode du fusible thermique (100), est une borne d'entrée de tension ou de courant (Vin) ;
la première pastille d'électrode extérieure (1), qui est connectée électriquement à la première extrémité d'électrode du fusible thermique (100) et à la première surface d'électrode de la diode (200), est une borne de sortie de tension ou de courant (Vout) ; et
la troisième pastille d'électrode extérieure (3), qui est connectée électriquement à la seconde surface d'électrode de la diode (200), est une borne de terre (GND) .

12. Dispositif de protection de circuit selon la revendication 11, dans lequel :
des surfaces de la première pastille d'électrode extérieure (1), la deuxième pastille d'électrode extérieure (2) et la troisième pastille d'électrode extérieure sont comprises dans le même plan.

13. Dispositif de protection de circuit selon l'une des revendications 1 à 12, dans lequel :
une cavité interne (510) est formée dans la première couche d'isolation (500), et une partie centrale du fusible thermique (100) est reçue à l'intérieur de la cavité interne (510).
